# EUROPEAN PATENT APPLICATION

(11) **EP 4 459 829 A1**
(43) Date of publication of application: **06.11.2024**
(21) Application number: 24169190.6
(22) Date of filing: 09.04.2024
(51) Int. Cl.: H02J 7/00, H01M 10/48, B25F 5/00, G01R 31/36

(54) **BATTERY PACK**

(30) Priority: 17.04.2023 CN 202310409556
(71) Applicant: Techtronic Cordless GP, Anderson, SC 29621 (US)
(72) Inventor: WANG, Ren jie, Dongguan City (CN)
(74) Representative: Novagraaf Group

(57) **Abstract**

The present invention relates to a battery pack that is connectible to an electric tool to power the electric tool and is connectible to a charging device to obtain energy from the charging device, the battery pack comprising a first state detection device (130), a first controller (140), a memory (170), and an electricity meter, the first state detection device being capable of detecting an abnormal state of the battery pack and storing same in the memory, the battery pack being capable of obtaining an abnormal state signal from the electric tool and/or the charging device and storing same in the memory, the electricity meter having a battery level display mode and an abnormal state display mode, wherein in the abnormal state display mode, an abnormal state stored in the memory is displayed according to a predetermined priority.

## Description

### Technical Field

The present invention relates to a battery pack, and in particular to a battery pack used for an electric tool and capable of being charged by a charging device.

### Background Art

In order to make an electric tool more portable, usually a battery pack consisting of a plurality of secondary batteries is used to supply power, and when the battery pack is about to be depleted, a low battery level state is indicated and a user can charge the battery pack by using a charging device to prevent the battery pack from being over-discharged, thereby reusing the battery pack and extending the life cycle thereof.

Generally, a battery pack is provided with an electricity meter, and in some application scenarios, the electricity meter indicates the battery level of the battery pack by means of a combination of lighting states of a plurality of LED lights. A user can estimate the approximate battery level of the battery pack by means of the lighting states of the LEDs, so as to rationally arrange the use of the battery pack according to work needs, and charge the battery pack in a timely manner.

However, an electricity meter is typically only used to indicate the remaining battery level of a battery pack.

Moreover, some abnormalities may occur when a battery pack is being charged and discharged. For example, when a battery pack being discharged, it may heat up due to prolonged operation, and a state detection device, especially a temperature sensor, in the battery pack or an electric tool will detect an increase in temperature and over-temperature protection is then triggered to stop the operation of the electric tool. In this case, the user would have no idea what happened or why the electric tool suddenly stopped operating. Therefore, it is necessary to provide an indicator device for indicating to a user what abnormality is occurring. This helps to improve the system robustness and avoid unnecessary user complaints.

Additional indicator devices are usually used to indicate to users what abnormalities are occurring. If an electricity meter is used to indicate various abnormalities to users, the following problems may occur: how to use the electricity meter to indicate various abnormalities, when to indicate these abnormalities to users, and, when the battery pack and the electric tool or charging device simultaneously have a plurality of abnormalities, how to indicate these abnormalities to users.

### Summary of the Invention

An obj ective of the present invention is to provide a battery pack that is connectible to an electric tool to power the electric tool and is connectible to a charging device to obtain energy from the charging device, the battery pack comprising a first state detection device, a first controller, a memory, and an electricity meter, the first state detection device being capable of detecting an abnormal state of the battery pack and storing same in the memory, the battery pack being capable of obtaining an abnormal state signal from the electric tool and/or the charging device and storing same in the memory, the electricity meter having a battery level display mode and an abnormal state display mode, wherein in the abnormal state display mode, an abnormal state stored in the memory is displayed according to a predetermined priority.

Preferably, the predetermined priority comprises a first priority, a second priority, and a third priority; the first priority comprises an abnormal state of the battery pack, the second priority comprises an abnormal state of the electric tool, and the third priority comprises an abnormal state of the charging device.

Furthermore, in the abnormal state display mode, the electricity meter gives priority to displaying an abnormal state of the first priority; if there is no abnormal state of the first priority, then an abnormal state of the second priority is displayed; if there is no abnormal state of the second priority, then an abnormal state of the third priority is displayed.

Preferably, the battery pack further comprises a button, which when pressed can trigger the electricity meter so that the electricity meter enters the battery level display mode or the abnormal state display mode.

More preferably, short pressing the button causes the electricity meter to enter the battery level display mode, and long pressing the button causes the electricity meter to enter the abnormal state display mode.

Preferably, the first state detection device is configured to detect at least one abnormal state of the battery pack and generate a first state signal accordingly; the first controller is configured to be connectible to the first state detection device to obtain the first state signal from the first state detection device; and the memory is configured to store the first state signal as a first priority. Thus, even when the battery pack is not connected to an electric tool and a charging device, an abnormal state of the battery pack itself can still be indicated with a specified priority via the electricity meter.

Preferably, the first controller is further configured to directly or indirectly connect to a second state detection device on the electric tool and/or a third state detection device on the charging device when the battery pack is connected to the electric tool and/or the charging device, the second state detection device and the third state detection device being configured to respectively detect at least one abnormal state of the electric tool and charging device, and send a second state signal and a third state signal to the first controller, wherein the memory is further configured to respectively store the second state signal and the third state signal as a second priority and a third priority. Thus, when connected to an electric tool and/or a charging device, the battery pack can indicate, with a specified priority via an electricity meter, an abnormal state received from the electric tool or charging device and an abnormal state of the battery pack itself.

Preferably, the electricity meter comprises a plurality of LED lights, which form layout patterns by means of respective lighting states to indicate different battery level states and abnormal states.

More preferably, in the battery level display mode and the abnormal state display mode, the battery level states and the abnormal states are displayed differently in a constantly lit manner and a flashing manner, respectively.

Preferably, the at least one abnormal state of the battery pack comprises at least one of the battery pack having an excessively high or excessively low temperature, having unbalanced cells, having an excessively low battery level, and being depleted; the at least one abnormal state of the electric tool comprises at least one of the electric tool having an excessively high or excessively low temperature, having a fault, being used incorrectly, and having a parameter redefined; and the at least one abnormal state of the charging device comprises at least one of the charging device having an excessively high or excessively low temperature, and having a fault.

Preferably, when an abnormal state is eliminated, the first controller can clear the abnormal state from the memory.

Preferably, the battery pack may further comprise a log memory, wherein when an abnormal state is cleared, the abnormal state is written into the log memory, making it convenient for a maintenance centre to maintain the product and track abnormal events (different events will be written into different addresses in the memory, and the number of occurrences of the same event can be accumulated).

A battery pack according to the present invention has at least one of the following advantages:
1. Ability to eliminate the need for an abnormal state indicator and reduce the number of accessories of the battery pack, thereby reducing costs.
2. Ability to indicate battery levels or abnormal states of the battery pack according to user needs.
3. Ability to visually display, in a flashing manner, an abnormal state that has occurred.
4. Ability to give priority to displaying abnormal states with circumstances that are serious or need to be dealt with urgently.
5. Improving the robustness and durability of a product.

### Brief Description of the Drawings

To better understand the above and other objectives, features, advantages and functions of the present invention, reference may be made to the preferred embodiments shown in the drawings. In the drawings, identical reference signs denote identical components. It should be understood by a person skilled in the art that the drawings are intended to schematically illustrate preferred embodiments of the present invention, without imposing any limitations on the scope of the present invention, and that the various components in the drawings are not drawn to scale.
Fig. 1 is a schematic diagram of a battery pack of the present invention connected to an electric tool and a charging device, respectively;
Fig. 2 is a schematic diagram of the structure of a battery pack of the present invention;
Fig. 3 is a schematic diagram of the structure of an electric tool electrically connected to a battery pack of the present invention;
Fig. 4 is a schematic diagram of the structure of a charging device electrically connected to a battery pack of the present invention; and
Fig. 5 is an embodiment of an electricity meter for a battery pack of the present invention, wherein each pattern displayed indicates a corresponding range of battery level or corresponding type of abnormal state.

### Detailed Description of the Invention

Specific embodiments of the present invention are now described in detail with reference to the drawings. The embodiments described here are merely preferred embodiments according to the present invention. A person skilled in the art could conceive of other ways of implementing the present invention on the basis of the preferred embodiments, and such other ways shall likewise fall within the scope of the present invention.

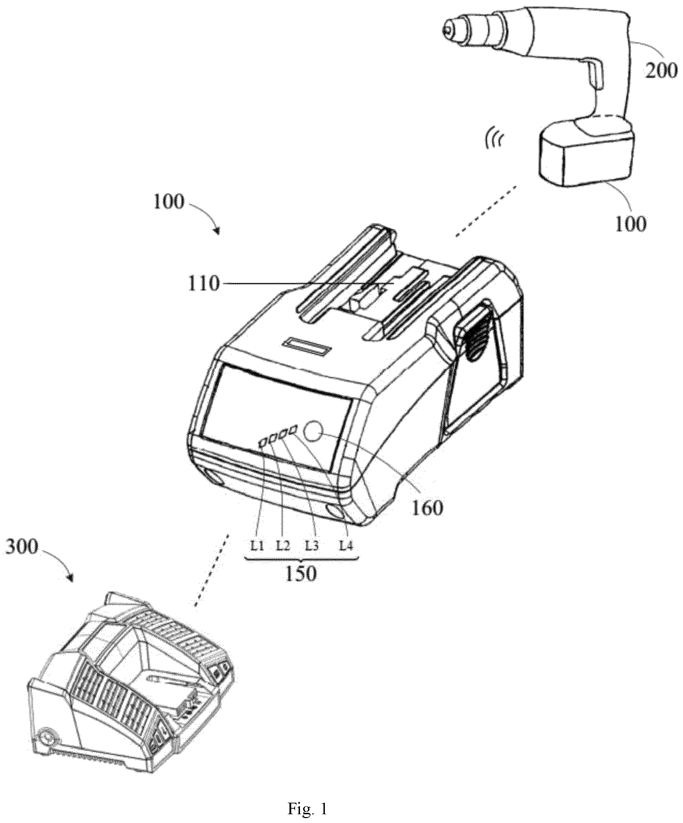

Fig. 1 shows a battery pack 100 of the present invention, comprising a housing 110 configured to be capable of connecting the battery pack 100 to an electric tool 200 or a charging device 300. An electricity meter 150 and a button 160 are provided on the housing 110, wherein the electricity meter 150 comprises four LED lights L1-L4, namely, LED lights No. 1 to No. 4 from top to bottom; the button 160 is configured to be capable of activating the electricity meter 150. The way in which the electricity meter 150 gives an indication and the means of operating the button 160 will be detailed below.

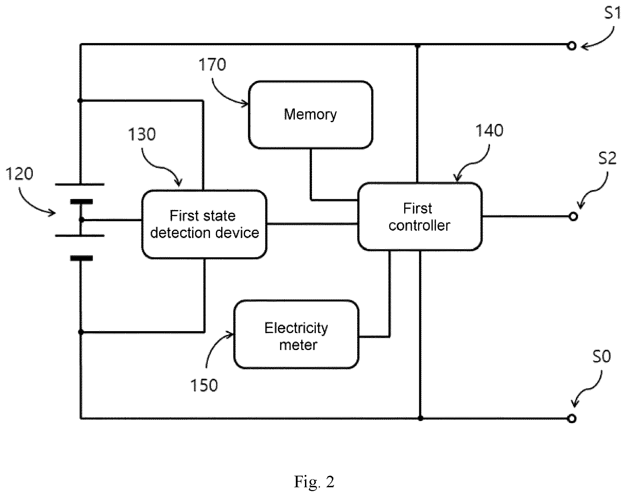

Fig. 2 schematically shows some electronic components of the battery pack 100 of the present invention, including a battery unit 120 located within the housing 110, the battery unit 120 being composed of a plurality of secondary batteries and configured to supply power externally or provide charging internally by means of an upper terminal S1 and a lower terminal S0.

The battery pack 100 further comprises a first state detection device 130 configured to detect the battery level of the battery unit 120 of the battery pack 100 and send a battery level signal accordingly, and to detect at least one abnormal state of the battery pack 100 and send, according to the at least one abnormal state of the battery pack 100, a corresponding first state signal. The first state detection device 130 may be a temperature sensor for measuring the temperature of the battery unit 120, a voltmeter for measuring the voltage of the battery unit 120 or of each of its batteries, an ammeter for measuring the current flowing through the battery unit 120, etc.

The battery pack 100 further comprises a first controller 140 configured to connect to the first state detection device 130 to receive a battery level signal and a first state signal from the first state detection device 130. The first controller 140 is further configured to connect to the electricity meter 150 to send the battery level signal and the first state signal to the electricity meter 150. The electricity meter 150 has a battery level display mode and an abnormal state display mode, and the electricity meter 150 enters the battery level display mode or the abnormal state display mode on the basis of the operation of the button 160, and then displays a corresponding pattern according to a battery level signal or first state signal, so that a user can learn of the state of the battery pack 100, for example, the remaining battery level of the battery unit 120 and/or an abnormal state of the battery pack, by observing the electricity meter 150 from the outside of the battery pack 100.

In one embodiment, a user short presses the button 160 (for a duration less than 5s, for example) so that the electricity meter 150 displays the remaining battery level of the battery unit 120 according to a battery level signal, and long presses the button (for a duration longer than or equal to 5s, for example) so that the electricity meter 150 displays a corresponding pattern according to a first state signal.

The first controller 140 is further configured to communicate with the outside through a communication terminal S2, and, especially when the battery pack 100 is connected to the electric tool 200 or the charging device 300, the first controller communicates with the electric tool 200 or the charging device 300 to obtain a state signal of an abnormal state thereof from the electric tool 200 or the charging device 300.

The battery pack 100 further comprises a memory 170 configured to, after the first controller 140 obtains a state signal detected by the first state detection device 130, or after obtaining, from the electric tool 200 and/or the charging device 300, a state signal of an abnormal state thereof, be capable of storing the abnormal state in the memory 170. For example, an abnormal state of the battery pack 100 is stored as a first priority, an abnormal state of the electric tool 200 is stored as a second priority, and an abnormal state of the charging device 300 is stored as a third priority. When the button 160 is long pressed so that the electricity meter 150 enters the abnormal state display mode, the first controller 140 reads the state signals of each stored abnormal state and the priorities thereof from the memory 170, and sends the state signal with the highest priority among the read state signals to the electricity meter 150 accordingly. Therefore, according to the severity, urgency and other characteristics of abnormal states, higher priorities can be set for abnormal states with circumstances that are serious or need to be dealt with urgently, so that these states are displayed first.

The priorities of each state signal stored in the memory 170 can also be modified by users or manufacturers so as to set the priorities of each state signal according to actual needs.

In addition, when an abnormal state is eliminated, the first controller 140 can also clear the abnormal state from the memory 170, so that the latest abnormal state can be correctly read the next time the system is started. The battery pack 100 may further comprise a log memory, and when the first controller 140 clears an abnormal state from the memory 170, the abnormal state or related abnormal event can be written into the log memory, making it convenient for a maintenance centre to maintain the product and track abnormal events. For example, different events will be written into different addresses in the memory, and the number of occurrences of the same event can be accumulated.

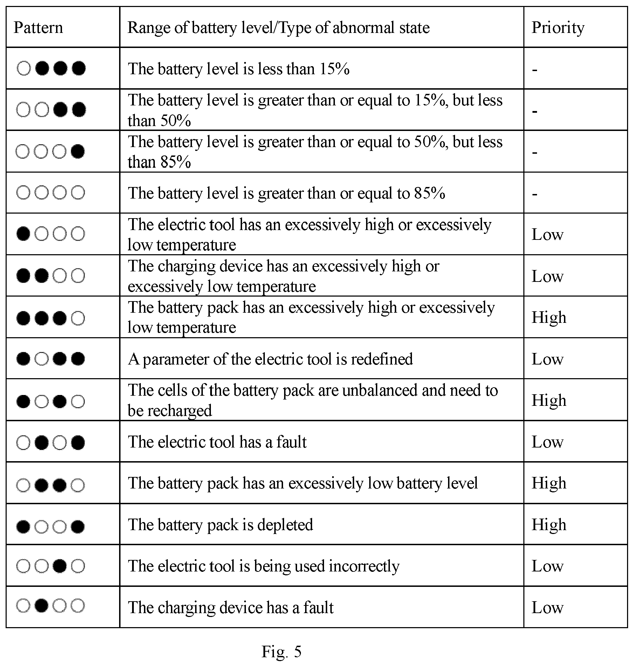

With reference to the table in Fig. 5, a detailed description of an embodiment of the electricity meter 150 of the battery pack 100 of the present invention will be provided below, wherein an empty circle represents a lit LED light, while a solid circle represents an unlit LED light. Thus, 4 LED lights can display up to 16 patterns corresponding to different states.

As shown in Fig. 5, when the remaining battery level of the battery unit 120 of the battery pack 100 is greater than or equal to 85%, all 4 LED lights are lit; when the remaining battery level of the battery unit 120 of the battery pack 100 is greater than or equal to 50%, but less than 85%, LED lights No. 1 to 3 are lit; when the remaining battery level of the battery unit 120 of the battery pack 100 is greater than or equal to 15%, but less than 50%, LED lights No. 1 and 2 are lit; and when the remaining battery level of the battery unit 120 of the battery pack 100 is less than 15%, only LED light No. 1 is lit.

In addition, when the temperature of the battery pack 100 is excessively high or excessively low, only LED light No. 4 is lit; when the cells of the battery pack 100 are unbalanced and need to be recharged, LED lights No. 2 and No. 4 are lit; when the battery level of the battery pack 100 is excessively low, LED lights No. 1 and 4 are lit; and when the battery pack 100 is depleted, LED lights No. 2 and 3 are lit.

Although in Fig. 5 the priorities of the above abnormal states are set as "high" only, namely, the first priority, more detailed priority division can still be set using the memory 170, for example, setting the priority of the abnormal state of "the battery pack having an excessively high or excessively low temperature" as the highest priority, so that when this abnormal state occurs, it is displayed first for a user to identify same and take corresponding measures to eliminate the abnormal state and its negative impact.

In one embodiment, an abnormal state related to a battery pack may be set as the first priority (high priority), which gives priority to displaying relevant information of the battery pack, such that faults of the battery pack are cleared first to avoid serious accidents. An abnormal state related to an electric tool may be set as the second priority (medium priority), and an abnormal state related to a charging device may be set as the third priority (low priority).

Specifically, in order to further distinguish between battery level display and abnormal state display, patterns corresponding to different battery levels may be displayed in a constantly lit manner, while patterns corresponding to different abnormal states may be displayed in a flashing manner, so that the patterns are more identifiable and the total number of patterns that the LEDs can display also increases.

In another embodiment, 5 or more LED lights may also be arranged for the electricity meter 150 to allow for more detailed power level division and/or indicate more abnormal states.

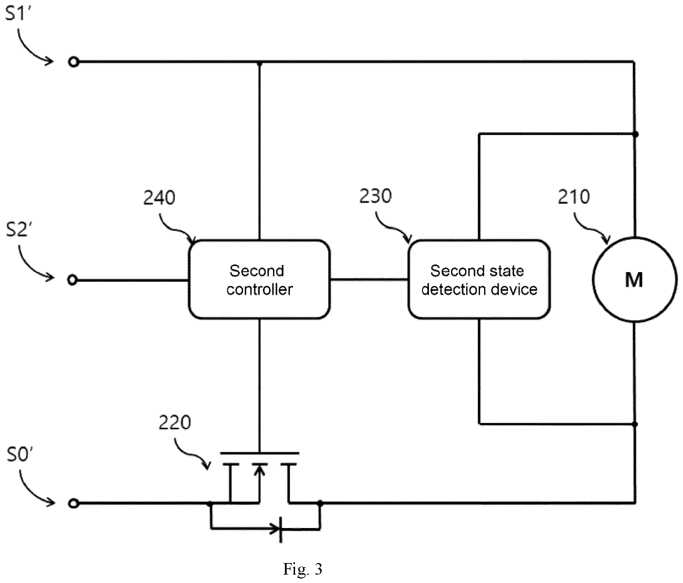

Fig. 3 schematically shows some electronic components of the electric tool 200, including an electric motor 210 and a controllable switch 220, the electric motor 210 being connected to the battery pack 100 via an upper terminal S1' and a lower terminal S0' of the electric tool 200 so as to be driven by the battery pack 100, and the controllable switch 220 being arranged between the electric motor 210 and the lower terminal S0' and configured to operably connect/disconnect the electrical power supply to the electric motor 210.

The electric tool 200 further comprises a second state detection device 230, which is configured to detect at least one abnormal state of the electric tool 200 and send, according to the at least one abnormal state of the electric tool 200, a corresponding second state signal. The second state detection device 230 may be a temperature sensor for measuring the temperature of the electric motor 210 and/or a second controller 240, a voltmeter for measuring the input voltage of the electric motor 210, an ammeter for measuring the current flowing through the electric motor 210, etc.

The electric tool 200 further comprises a second controller 240, which is configured to connect to the controllable switch 220 and the second state detection device 230 to obtain a second state signal from the second state detection device 230 and control, according to the second state signal, the turning-on/off of the controllable switch 220, thereby controlling the driving of the electric motor 210. In addition, the second controller 240 is further configured to connect to the first controller 140 via a communication terminal S2' when the battery pack 100 is installed onto the electric tool 200, so as to send the second state signal to the first controller 140 and store same in the memory 170, preferably stored as a second priority. When the button 160 is long pressed so that the electricity meter 150 enters the abnormal state display mode, the first controller 140 reads the state signals of each stored abnormal state and the priorities thereof from the memory 170, and sends the state signal with the highest priority among the read state signals to the electricity meter 150 accordingly. Preferably, when there is no abnormal state of the first priority, the first controller 140 sends a state signal of an abnormal state of the second priority, namely, a second state signal, to the electricity meter 150. Then, the electricity meter 150 receives the second state signal from the first controller 140 and displays a corresponding pattern according to the second state signal.

As shown in Fig. 5, when the temperature of the electric tool 200 is excessively high or excessively low, LED lights No. 2 to 4 are lit; when the electric tool 200 has a fault, LED lights No. 1 and 3 are lit; when the electric tool 200 is being used incorrectly, LED lights No. 1, 2 and 4 are lit; and when a parameter of the electric tool 200 is redefined, for example, being remotely updated by means of a mobile application, only LED light No. 2 is lit.

Here, the priorities of the above abnormal states are set as "low", this means that when the button 160 is long pressed and the first controller 140 simultaneously receives a first state signal and a second state signal from the first state detection device 130 and the second controller 240, the first controller 140 always sends the first state signal to the electricity meter 150 so that the electricity meter 150 indicates the abnormality that has occurred in the battery pack 100, which means that the first state signal has a higher priority than the second state signal.

Similarly, a user can still set more detailed priority division using the memory 170, for example, setting the priority of the abnormal state of "the electric tool having an excessively high or excessively low temperature" as the second highest priority, so that when this abnormal state occurs and the situation of "the battery pack having an excessively high or excessively low temperature" does not occur, this abnormal state is displayed first for the user to identify same and take corresponding measures to eliminate the abnormal state and its negative impact.

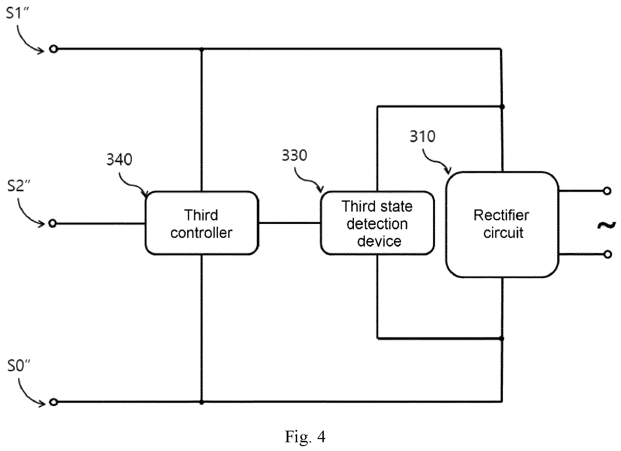

Fig. 4 schematically shows some electronic components of the charging device 300, including a rectifier circuit 310, which is capable of converting an alternating current from a power grid into a direct current, and supplying electricity to the battery pack 100 by means of an upper terminal S1" and a lower terminal S0" of the charging device 300.

The charging device 300 further comprises a third state detection device 330, which is configured to detect at least one abnormal state of the charging device 300 and send, according to the at least one abnormal state of the charging device 300, a corresponding third state signal. The third state detection device 330 may be a temperature sensor for measuring the temperature of the charging device 300, especially that of the rectifier circuit 310, or a fault detection device for detecting a fault in the charging device 300, etc.

The charging device 300 further comprises a third controller 340, which is configured to be capable of adjusting the energy supplied to the battery pack 100. In addition, the third controller 340 is configured to connect to the third state detection device 330 to obtain a third state signal from the third state detection device 330, and is further configured to connect to the first controller 140 via a communication terminal S2" of the charging device 300 when the battery pack 100 is installed onto the charging device 300, so as to send the third state signal to the first controller 140 and store same in the memory 170, preferably stored as a third priority. When the button 160 is long pressed so that the electricity meter 150 enters the abnormal state display mode, the first controller 140 reads the state signals of each stored abnormal state and the priorities thereof from the memory 170, and sends the state signal with the highest priority among the read state signals to the electricity meter 150 accordingly. Preferably, when there is no abnormal state of the first or second priority, the first controller 140 sends a state signal of an abnormal state of the third priority, namely, a third state signal, to the electricity meter 150. Then, the electricity meter 150 receives the third state signal from the first controller 140, and displays a corresponding pattern according to the third state signal.

As shown in Fig. 5, when the temperature of the charging device 300 is excessively high or excessively low, LED lights No. 3 and 4 are lit; and when the charging device 300 has a fault, LED lights No. 1, 3, and 4 are lit.

Here, the priorities of the above abnormal states are set as "low", this means that when the button 160 is long pressed and the first controller 140 simultaneously receives a first state signal and a third state signal from the first state detection device 130 and the third controller 340, the first controller 140 always sends the first state signal to the electricity meter first, which means that the first state signal has a higher priority than the third state signal.

Similarly, a user can still set more detailed priority division using the memory 170, for example, setting the priority of the abnormal state of "the charging device having an excessively high or excessively low temperature" as the second highest priority, so that when this abnormal state occurs and the situation of "the battery pack having an excessively high or excessively low temperature" does not occur, this abnormal state is displayed first for the user to identify same and take corresponding measures to eliminate the abnormal state and its negative impact.

In addition, in another embodiment, the second state detection device 230 may also be configured to directly connect to the first controller 140 through the communication terminal S2' of the electric tool 200 to send a second state signal directly to the first controller 140. Similarly, the third state detection device 330 may also be configured to directly connect to the first controller 140 through the communication terminal S2" of the charging device 300 to send a third state signal directly to the first controller 140.

In some embodiments, when a plurality of different abnormal states with the same priority occur simultaneously, a certain abnormal state, for example, an abnormal state read first by the first controller 140, may be randomly displayed.

The above description of various embodiments of the present invention is provided to a person of ordinary skill in the relevant art for descriptive purposes. The present invention is not intended to be exclusive or limited to a single disclosed embodiment. On the basis of what is described above, a person of ordinary skill in the art will understand various substitutes for and variants of the present invention. Therefore, although some alternative embodiments have been specifically described, a person of ordinary skill in the art will understand, or develop with relative ease, other embodiments. The present invention is intended to include all substitutes for, alterations to, and variants of the present invention described herein, as well as other embodiments falling within the spirit and scope of the present invention described above.

### Key to reference signs:

- 100: Battery pack
- 110: Housing
- 120: Battery unit
- 130: First state detection device
- 140: First controller
- 150: Electricity meter
- 160: Button
- 170: Memory
- 200: Electric tool
- 210: Electric motor
- 220: Controllable switch
- 230: Second state detection device
- 240: Second controller
- 300: Charging device
- 310: Rectifier circuit
- 330: Third state detection device
- 340: Third controller
- S0/S0'/S0": Lower terminal
- S1/S1'/S1": Upper terminal
- S2/S2'/S2": Communication terminal
- L1-L4: LED light

## Claims

1. Battery pack (100) that is connectible to an electric tool (200) to power the electric tool and is connectible to a charging device (300) to obtain energy from the charging device, the battery pack comprising a first state detection device (130), a first controller (140), a memory (170), and an electricity meter (150), the first state detection device being capable of detecting an abnormal state of the battery pack and storing same in the memory, the battery pack being capable of obtaining an abnormal state signal from the electric tool and/or charging device and storing same in the memory, the electricity meter having a battery level display mode and an abnormal state display mode, wherein in the abnormal state display mode, an abnormal state stored in the memory is displayed according to a predetermined priority.

2. Battery pack according to Claim 1, **characterized in that** the predetermined priority comprises a first priority, a second priority, and a third priority; the first priority comprises an abnormal state of the battery pack, the second priority comprises an abnormal state of the electric tool, and the third priority comprises an abnormal state of the charging device.

3. Battery pack according to Claim 2, **characterized in that** in the abnormal state display mode, the electricity meter gives priority to displaying an abnormal state of the first priority; if there is no abnormal state of the first priority, then an abnormal state of the second priority is displayed; if there is no abnormal state of the second priority, then an abnormal state of the third priority is displayed.

4. Battery pack according to Claim 1, **characterized in that** the battery pack further comprises a button (160), which when pressed can trigger the electricity meter so that the electricity meter enters the battery level display mode or the abnormal state display mode.

5. Battery pack according to Claim 4, **characterized in that** short pressing the button causes the electricity meter to enter the battery level display mode and long pressing the button causes the electricity meter to enter the abnormal state display mode.

6. Battery pack according to Claim 1, **characterized in that**
the first state detection device is configured to detect at least one abnormal state of the battery pack and generate a first state signal accordingly;
the first controller is configured to connect to the first state detection device to obtain the first state signal from the first state detection device; and
the memory is configured to store the first state signal as a first priority.

7. Battery pack according to Claim 6, **characterized in that** the first controller is further configured to directly or indirectly connect to a second state detection device (230) on the electric tool and/or a third state detection device (330) on the charging device when the battery pack is connected to the electric tool and/or the charging device, the second state detection device and the third state detection device being configured to respectively detect at least one abnormal state of the electric tool and charging device, and send a second state signal or a third state signal to the first controller, wherein the memory is further configured to respectively store the second state signal and the third state signal as a second priority and a third priority.

8. Battery pack according to Claim 2, **characterized in that** the electricity meter comprises a plurality of LED lights, which form layout patterns by means of respective lighting states to indicate different battery level states and abnormal states.

9. Battery pack according to Claim 8, **characterized in that** in the battery level display mode and the abnormal state display mode, the battery level states and the abnormal states are displayed differently in a constantly lit manner and a flashing manner, respectively.

10. Battery pack according to Claim 6, **characterized in that** the at least one abnormal state of the battery pack comprises at least one of the battery pack having an excessively high or excessively low temperature, having unbalanced cells, having an excessively low battery level, and being depleted.

11. Battery pack according to Claim 7, **characterized in that** the at least one abnormal state of the electric tool comprises at least one of the electric tool having an excessively high or excessively low temperature, having a fault, being used incorrectly, and having a parameter redefined.

12. Battery pack according to Claim 7, **characterized in that** the at least one abnormal state of the charging device comprises at least one of the charging device having an excessively high or excessively low temperature, and having a fault.

13. Battery pack according to Claim 1, **characterized in that** when an abnormal state is eliminated, the first controller (140) clears the abnormal state from the memory (170).

14. Battery pack according to Claim 13, **characterized in** further comprising a log memory, wherein when an abnormal state is cleared, the abnormal state is written into the log memory.
